# EUROPÄISCHE PATENTSCHRIFT

(11) **EP 0 339 386 B1**
(45) Veröffentlichungstag und Bekanntmachung des Hinweises auf die Patenterteilung: **13.07.1994**
(21) Anmeldenummer: 89106622.7
(22) Anmeldetag: 13.04.1989
(51) Int. Cl.: H01L 31/10

(54) **Als Fotodetektor verwendbare Bipolartransistorstruktur**
Bipolar transistor structure for use as a photodetector
Structure de transistor bipolaire utilisable comme photodétecteur

(30) Priorität: 29.04.1988 DE 3814656
(43) Veröffentlichungstag der Anmeldung: 02.11.1989
(73) Patentinhaber: SIEMENS AKTIENGESELLSCHAFT, 80333 München (DE)
(72) Erfinder: Bock, Wolfgang, D-8000 München 40 (DE)

(56) Entgegenhaltungen:
- DE-A- 3 001 899
- SIEMENS-FORSCH.- U. ENTWICKL.-BER., Band 13, Nr. 5, Mai 1984, Seiten 246-252, Springer-Verlag; A.W. WIEDER: "Self-aligned bipolar technology - new chances for very-high-speed digital integrated circuits"
- ELECTRONICS LETTERS, Band 24, Nr. 13, 23. Juni 1988, Seiten 808-810, Stevenage, Herts, GB; W. BOCK et al.: "Optical detection up to 2.5 Gbit/s with a standard high-speed self-aligned silicon bipolar transistor"

## Beschreibung

Die Erfindung betrifft die Verwendung einer Bipolartransistorstruktur in einem Siliziumsubstrat mit vertikaler Emitter-Basis-Kollektorfolge, mit einem Emitteranschlußbereich und einem metallischen Emitterkontakt zur Detektion von optischen Datenraten.

Zur optischen Detektion in der Nachrichtentechnik werden Fotodetektoren und low-noise Verstärker verwendet. Im Interesse einer großen detektierbaren Datenrate werden Anordnungen mit hohen Schaltgeschwindigkeiten angestrebt.

Eine monolithische Integration von Fotodetektoren und Verstärkerstufen ist zum Beispiel aus Wang H., Ankri D., "Monotlithic integrated photoreceiver implemented with GaAs/GasAlAs heterojunction bipolar phototransistor and transistors", Electron. Lett., 1986, 22, Seiten 391 - 393, aus Bar-Chaim N., Harder Ch., Katz J., Margalit S., Yariv A., Ury I.: "Monotlithic integration of a GaAlAs buried-heterostructure laser and a bipolar phototransistor", Appl. Phys. Lett., 1982, Band 40(7), Seiten 556 - 557 bekannt. Dabei werden aus A_{III}B_{V} Materialien bestehende Fototdetektoren in integrierte Schaltungen eingebaut. Damit können empfindiche Fotodetektoren mit einem guten Frequenzverhalten hergestellt werden, eine hohe Integration wird jedoch nicht erreicht.

Aus DE-A-3 001 899 ist ein Planar-Fototransistor bekannt. Dieser umfaßt eine Kollektorzone, eine in die Kollektorzone eingelassene Basiszone und eine in die Basiszone eingelassene Emitterzone. Die Emitterzone füllt dabei an der Halbleiteroberfläche unter Freilassung des Basiskontaktierungsbereichs möglichst weitgehend die Basiszone aus. Der Emitteranschlußkontakt ist kleinflächig gegenüber der Emitterzone ausgebildet. Die Emitterzone ist derart beschichtet, daß die Strahlung im wesentlichen durch die Emitterzone in den Halbleiterkörper eindringt. Sowohl der Emitteranschlußkontakt als auch der Basisanschlußkontakt sind möglichst kleinflächig ausgebildet, um die zur Erzeugung des Fotostroms wirksame Fläche möglichst wenig zu reduzieren. Diese kleinflächige Ausbildung von Basisanschlußkontakt und Emitteranschlußkontakt hat zur Folge, daß dieser Fototransistor zur optischen Detektion großer Datenraten aufgrund seiner Schaltgeschwindigkeit nur bedingt geeignet ist.

Der Erfindung liegt die Aufgabe zugrunde, eine lichtempfindliche Bipolarstransistorstruktur anzugeben mit hohen Schaltgeschwindigkeiten, die zur Integration in hochintegrierte Schaltungen geeignet ist.

Diese Aufgabe wird erfindungsgemäß durch eine lichtempfindliche Bipolartransistorstruktur der eingangs genannten Art gelöst, die durch die Merkmale des Anspruchs 1 gekennzeichnet ist.

Da der aktive Transistorbereich, der durch die vertikale Emitter-Basis-Kollektorfolge gebildet wird, nur von lichtdurchlässigen Schichten bedeckt ist, ist es möglich, mit Licht direkt in die Bipolartransistorstruktur einzustrahlen. Das Licht erzeugt in der aus Basis und Kollektor gebildeten Diode (BC-Diode) Elektronen-Lochpaare, die einen Fotostrom verursachen. Die Bipolartransistorstruktur bildet einen Fotodetektor.

Es ist besonders vorteilhaft, Bipolartransistoren zu verwenden, die durch einen selbstjustierenden Doppelpolysilizium-Prozeß gebildet sind. Diese Bipolartransistoren weisen hohe Schaltgeschwindigkeiten auf (siehe zum Beispiel Wieder A. W.: "Selfaligned bipolar technology-new chances for very high-speed digital integrated circuits", Siemens Forsch.-& Entwicklungsber., 1984, Band 13, Seiten 246 - 252). Damit ist in diesem Fall die detektierbare Datenrate gekoppelt mit der hohen Schaltgeschwindigket der Bipolartransistoren. Zur Herstellung der Bipolartransistorstruktur ist lediglich eine horizontale Deplazierung des Emitterkontaktes gegenüber der vertikalen Emitter-Basis-Kollektorfolge erforderlich. Die Bipolartransistorstruktur kann daher innerhalb von integrierten Schaltungen mit einem bekannten Bipolarprozeß (wie zum Beispiel in Wieder A. W.: Self-aligned bipolar technology-new chances for very highspeed digital integrated circuits", Siemens Forsch.-&Entwicklungsber., 1984, Band 13, auf den Seiten 246 - 252 beschrieben) hergestellt werden. Dadurch wird ein hohes Maß an Integration erzielt.

Die Bipolartransistorstruktur ist besonders geeignet zur Detektion von optischen Datenraten im Gbit/s-Bereich mit Wellenlängen kleiner/gleich 900 nm innerhalb von hochintegrierten Si-Bipolarschaltungen, da die Energie von Licht dieser Wellenlänge ausreicht, um in Silizium Elektron-Lochpaare zu erzeugen.

Weitere Ausgestaltungen der Erfindung gehen aus den Unteransprüchen hervor.

Im folgenden wird die Erfindung anhand der Figuren 1 bis 4 und eines Ausführungsbeispiels näher erläutert.
FIG 1 zeigt in schematischer Darstellung den Versuchsaufbau zur Messung der Fotoempfindlichkeit der Bipolartransistorstruktur.
FIG 2 zeigt die Abhängigkeit des Fotostroms von der eingestrahlten Lichtleistung bei der Messung in einer Anordnung nach FIG 1.
FIG 3 zeigt einen Schnitt durch einen selbstjustierten Bipolartransistor gemäß der Erfindung.
FIG 4 zeigt eine Draufsicht auf den Bipolartransistor aus FIG 3.

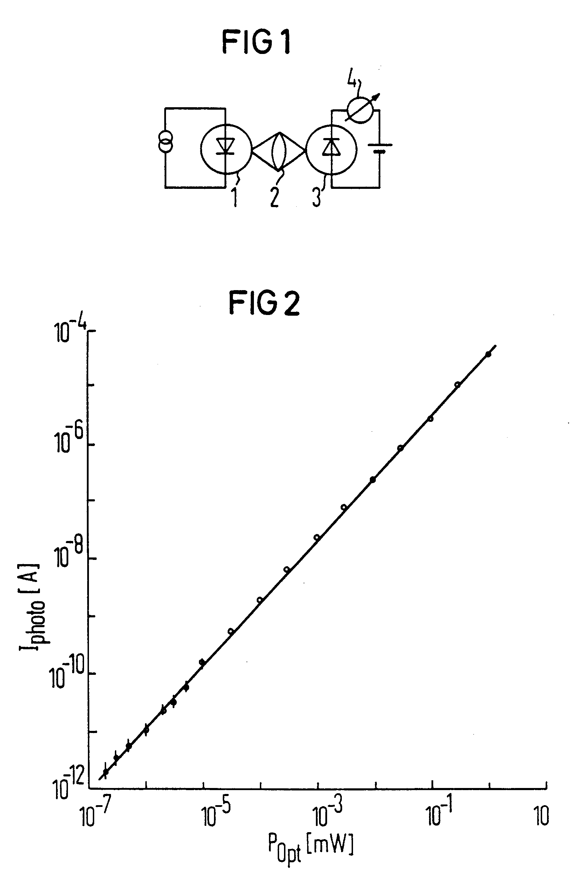

FIG 1 zeigt das Ersatzschaltbild eines Versuchsaufbaus zum Nachweis der Fotoempfindlichkeit eines erfindungsgemäßen Bipolartransistor, der durch einen selbstjustierenden Doppelpolysiliziumprozeß gebildet wurde. Das Licht einer Laserdiode 1 wird mit Hilfe einer Linsenanordnung 2 auf die aus Basis und Kollektor der Bipolartransistorstruktur gebildete Basis-Kollektordiode 3 fokussiert. Die Laserdiode 1 emittiert Licht einer Wellenlänge λ = 830 nm.

Der verwendete Bipolartransistor weist folgende Daten auf: Selbstjustierter npn-Transistor, Emitterfläche 2 x 8 »m², Basisfläche 6 x 12 »m², Basisweite 0,2 »m, Tiefe des vergrabenen Kollektors 1,6 »m, Basiswiderstand 150 Ohm, Kollektorwiderstand 50 Ohm, Kapazität des Basiskollektorübergangs 50 fF.

Mit einem Strommeßgerät 4 (siehe FIG 1) wird der in der Basiskollektordiode 3 erzeugte Fotostrom nachgewiesen.

Die Abhängigkeit des nachgewiesenen Fotostroms Iₚₕₒₜₒ von der eingestrahlten Lichtleistung Pₒₚₜ ist in FIG 2 dargestellt. Es zeigt sich eine lineare Abhängigkeit des Photostromes Iₚₕₒₜₒ von der Lichtleistung Pₒₚₜ. Licht der Wellenlänge 830 nm dringt etwa 20 »m tief in Silizium ein. Verglichen mit der Tiefe des Kollektors von 1,6 »m bedeutet diese Reichweite, daß der Bipolartransistor für das Licht durchlässig ist.

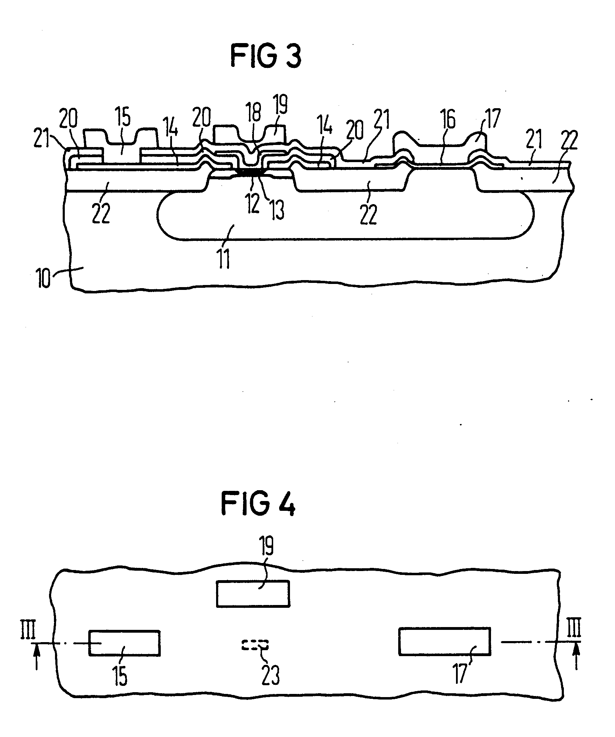

In FIG 3 ist ein erfindungsgemäßer durch einen Doppelpolysiliziumprozeß hergestellter Bipolartransistor dargestellt. Ein Substrat 10 aus Silizium enthält Feldoxidbereiche 22, die zur Trennung der aktiven Bauelementbereiche innerhalb des Substrats 10 dienen. Im Substrat 10 ist ein n-dotierter Kollektor 11, eine p-dotierte Basis 12 und ein n-dotierter Emitter 13 vorgesehen. Der Kollektor 11, die Basis 12 und der Emitter 13 sind so angeordnet, daß ihre aktiven Bereiche eine vertikale Folge bilden. Die Basis 12 ist so gestaltet, daß ihr inaktiver Bereich den Emitter 13 ringförmig umschließt. Über einen Basisanschlußbereich 14, der aus p-dotiertem Polysilizium besteht, ist die Basis 12 mit einem Basiskontakt 15 verbunden. Der Basisanschlußbereich sowie 14 dessen Flanken außerhalb des Bereichs des Basiskontaktes 15 sind mit einer Isolationsschicht 20 bedeckt. Der Kollektor 11 ist über einen Kollektoranschlußbereich 16, der aus n-dotiertem Polysilizium besteht, mit einem Kollektorkontakt 17 verbunden. Der Emitter 13 ist über einen Emitteranschlußbereich 18 mit einem Emitterkontakt 19 verbunden. Die freiliegende Oberfläche des Bipolartransistors ist mit einer schützenden Oxidschicht 21 bedeckt. Der Emitteranschlußbereich 18 ist so ausgebildet, daß der Emitterkontakt 19 außerhalb des Bereichs des aktiven Transistors angebracht werden kann.

Die Lage des Basiskontakts 15, des Kollektorkontakts 17, des Emitterkontakts 19 und des aktiven Transistorbereichs 23 wird anhand von FIG 4, die eine Draufsicht des Bipolartransistors aus FIG 3 darstellt, näher erläutert. Der Basiskontakt 15 und der Kollektorkontakt 17 liegen auf einer Linie in der Oberfläche des Substrats 10, durch die der in FIG 3 dargestellte Schnitt III-III durch den Bipolartransistor gelegt ist. Zwischen dem Basiskontakt 15 und dem Kollektorkontakt 17 liegt ein aktiver Transistorbereich 23, der durch die vertikale Folge von Kollektor 11, Basis 12 und Emitter 13 definiert wird. Er liegt auf derselben Linie wie der Basiskontakt 15 und der Kollektorkontakt 17. Seitlich versetzt zur Lage des Basiskontakts 15, des Kollektorkontakts 17 und des aktiven Transistorsbereichs 23 ist der Emitterkontakt 19 angeordnet. Dadurch wird sichergestellt, daß mit Licht direkt in den aktiven Transistorbereich 23 eingestrahlt werden kann. Dank der geringen Absorption von Licht einer Wellenlänge kleiner oder gleich 900 nm (Reichweite für λ = 830 nm ca. 20 »m) kann der Emitteranschlußbereich 18 (s. FIG 3) seine übliche Dicke haben.

Der beschriebene lichtempfindliche Bipolartransistor hat den Vorteil, daß er im bekannten Bipolarprozeß (siehe z.B. Wieder A.W.: Self-aligned bipolar technology-new chances for very high-speed digital integrated circuits, Siemens Forsch.-& Entwicklungsber., 1984, Band. 13, Seite 246-252) hergestellt werden kann, wobei kein zusätzlicher Prozeßschritt benötigt wird. Lediglich das Kontaktloch für den Emitterkontakt 19 muß an anderer Stelle angebracht werden. Die Eigenschaften des Bipolartransistors erlauben eine Detektion einer optischen Datenrate von bis zu 2,5 Gbit/s.

## Patentansprüche

1. Verwendung einer Bipolartransistorstruktur in einem Siliziumsubstrat mit vertikaler Emitter-Basis-Kollektorfolge, mit einem Emitteranschlußbereich und einem metallischen Emitterkontakt und mit folgenden Merkmalen:
a) es ist selbstjustierter Emitter-Basis-Bereich (12, 13) vorgesehen, wobei der Emitter (13) an die Oberfläche des Siliziumsubstrats (10) angrenzend zentral im Basisbereich (12) angeordnet ist, so daß unter dem Emitter (13) eine aktive Basis und den Emitter (13) ringförmig umschließend eine inaktive Basis, die seitlich des Emitters (13) an die Oberfläche des Siliziumsubstrats (10) angrenzt, angeordnet sind,
b) es ist ein Basisanschlußbereich (14) aus dotiertem Polysilizium vorgesehen, der oberhalb der inaktiven Basis angeordnet ist,
c) der Emitteranschlußbereich (18) enthält dotiertes Polysilizium, ist an der Oberfläche des Emitters (13) angeordnet und ist vom Basisanschlußbereich (14) durch eine Isolationsschicht (20) isoliert,
d) der Emitteranschlußbereich (18) erstreckt sich über den Emitter (13) hinaus auf die Oberfläche des Substrats (10),
e) der Emitterkontakt (19) überdeckt den Emitteranschlußbereich (18) nur teilweise, so daß der Emitter (13) im Bereich der vertikalen Emitter-Basis-Kollektorfolge nicht unterhalb des Emitterkontakts (19) liegt,
f) der Emitteranschlußbereich (18) ist im Bereich der vertikalen Emitter-Basis-Kollektorfolge lichtdurchlässig und in diesem Bereich auch nur von schwach absorbierenden Schichten bedeckt,
g) der Emitter (13) weist eine Fläche von 16 »m² auf,
zur Detektion von optischen Datenraten,

2. Verwendung nach Anspruch 1,
bei der optische Datenraten im Gbit/s-Bereich mit Wellenlängen kleiner/gleich 900 nm innerhalb hochintegrierter Siliziumbipolarschaltungen detektiert werden.

## Claims

1. Use of a bipolar transistor structure in a silicon substrate having a vertical emitter-base-collector sequence, having an emitter terminal region and a metallic emitter contact and having the following features:
a) a self-adjusted emitter-base region (12, 13) is provided, the emitter (13) being disposed onto the surface of the silicon substrate (10) centrally adjacent in the base region (12), so that there are disposed, under the emitter (13), an active base and, annularly surrounding the emitter (13), an inactive base, which adjoins the surface of the silicon substrate (10) laterally of the emitter (13),
b) a base terminal region (14) of doped polysilicon is provided, which region is disposed above the inactive base,
c) the emitter terminal region (18) includes doped polysilicon, is disposed on the surface of the emitter (13) and is insulated from the base terminal region (14) by an insulating layer (20),
d) the emitter terminal region (18) extends beyond the emitter (13) onto the surface of the substrate (10),
e) the emitter contact (19) only partially covers the emitter terminal region (18), so that the emitter (13) does not lie under the emitter contact (19) in the region of the vertical emitter-base-collector sequence,
f) the emitter terminal region (18) is optically transmitting in the region of the vertical emitter-base-collector sequence and, in this region, is also covered only by weakly absorbing layers,
g) the emitter (13) exhibits an area of 16 »m², for the detection of optical data rates.

2. Use according to Claim 1, in which optical data rates in the Gbit/s range are detected using wavelengths smaller than/equal to 900 nm within highly integrated silicon bipolar circuits.

## Revendications

1. Utilisation d'une structure de transistor bipolaire dans un substrat en silicium comportant une succession verticale émetteur-base-collecteur, ayant une zone de raccordement d'émetteur et un contact métallique d'émetteur, et présentant les particularités suivantes :
a) il est prévu une zone émetteur-base autoalignée (12, 13), l'émetteur (13) étant disposé dans une position centrée dans la zone de base (12) en étant contigu à la surface du substrat en silicium (10), de sorte qu'une base active est disposée en-dessous de l'émetteur (13) et qu'une base inactive, qui est contigüe latéralement à l'émetteur (13), sur la surface du substrat en silicium (10), est disposée en entourant annulairement l'émetteur (13),
b) il est prévu une zone de raccordement de base (14) qui est en polysilicium dopé et qui est disposée au-dessus de la base inactive,
c) la zone de raccordement d'émetteur (18) contient du polysilicium dopé, est disposée sur la surface de l'émetteur (13) et est isolée de la zone de raccordement de base (14) par une couche isolante (20),
d) la zone de raccordement d'émetteur (18) s'étend au-delà de l'émetteur (13) sur la surface du substrat (10),
e) le contact d'émetteur (19) recouvre seulement partiellement la zone de raccordement d'émetteur (18), de sorte que l'émetteur (13), dans la zone de la succession verticale émetteur-base-collecteur, n'est pas en-dessous du contact d'émetteur (19),
f) la zone de raccordement d'émetteur (18) est opaque dans la zone de la succession verticale émetteur-base-collecteur et n'est également recouverte, dans cette zone, que par des couches faiblement absorbantes,
g) l'émetteur (13) a une surface de 16 »m²,
pour la détection de débits de données optiques.

2. Utilisation selon la revendication 1, selon laquelle les débits de données optiques dans la gamme des G.bits/s avec des longueurs d'onde inférieures/ égales à 900 nm sont détectés à l'intérieur de circuits bipolaires en silicium à haute densité d'intégration.
